Europäisches Patentamt

European Patent Office

Office européen des brevets

(11) Publication number: 0 613 190 A2

# EUROPEAN PATENT APPLICATION

(21) Application number: 94102643.7

(22) Date of filing: 22.02.94

(51) Int. Cl.⁵: H01L 29/812, H01L 29/08

(30) Priority: 22.02.93 JP 32171/93

(43) Date of publication of application:
31.08.94 Bulletin 94/35

(84) Designated Contracting States:
DE DK FR GB SE

(71) Applicant: Sumitomo Electric Industries, Ltd.
5-33, Kitahama 4-chome, Chuo-ku
Osaka 541 (JP)

(72) Inventor: Nakajima, Shigeru, c/o Yokohama
Works of
Sumitomo Electric Ind., Ltd,
1, Taya-cho
Sakae-ku, Yokohama-shi, Kanagawa (JP)

(74) Representative: Kahler, Kurt, Dipl.-Ing.
Patentanwälte Kahler, Käck & Fiener
Maximilianstrasse 57
Postfach 12 49
D-87712 Mindelheim (DE)

(54) Schottky junction type field effect transistor and method of manufacturing the same.

(57) This invention has as its object to easily obtain a MESFET free from output distortion. For this purpose, in this invention, an $n^+$-type layer (4) is formed at a substrate position spaced apart from a gate electrode (7) by a distance of a side-etch amount $L_{g-n+}$. The $n^+$-type layer (4) has an impurity concentration and thickness such that a surface depletion layer generated depending on a surface level on the drain-side does not almost extend to the drain-side. An n'-type layer (5) as an intermediate concentration layer has an impurity concentration and thickness such that a drain-side end portion of a channel depletion layer generated upon applying a voltage to the gate electrode (7) extends to the drain-side with an increase in this applied voltage. Moreover, the $n^+$-type layer (4), a distance $L_{g-n+}$, and the n'-type layer (5) are formed to have a relationship in which a ratio of an extension length L of the drain-side end portion of the channel depletion layer from the drain-side end portion A of the gate electrode (7) to the drain-side, to a gate length $L_g$ falls within a predetermined range. Therefore, according to this invention, the long gate effect and the effect for the drain current in accordance with the square characteristics cancel each other, and an FET output changes linearly in response to an input.

## Fig. 4

## BACKGROUND OF THE INVENTION

### Field of the Invention

The present invention relates to a Schottky junction type field effect transistor (MESFET) in which a gate electrode Schottky-contacts a semiconductor substrate, and a method of manufacturing the same.

### Related Background Art

As a conventional MESFET of this type, a MESFET using a GaAs semiconductor material is known. GaAs MESFETs have been used in a variety of fields such as high-frequency elements and ultra high-speed ICs. In applications of GaAs MESFET to these high-frequency elements and ultra high-speed ICs, GaAs MESFET characteristics are advantageous in that an output signal is less distorted in response to an input signal.

The voltage vs. current characteristics of a MESFET generally have so-called square characteristics, and its drain current $I_{ds}$ is defined as follows:

$$I_{ds} = K(V_{th} - V_g)^2 \qquad (1)$$

where K is the proportional constant, $V_{th}$ is the threshold voltage, and $V_g$ is the gate voltage.

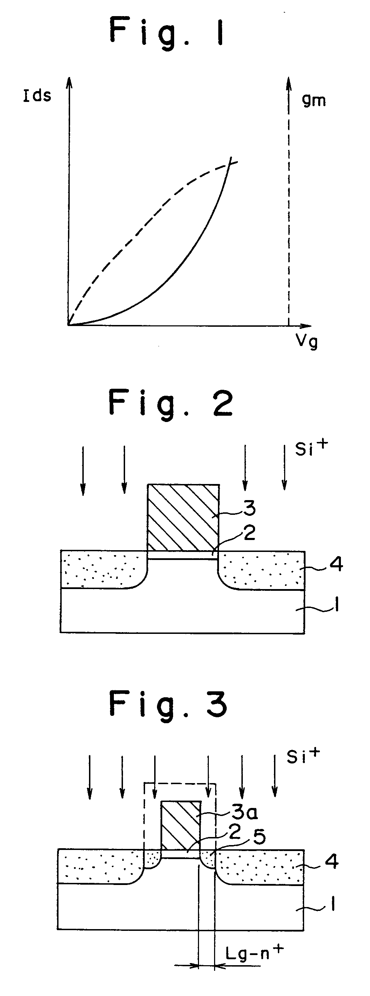

Typical square characteristics are shown in a graph of Fig. 1. The abscissa of this graph represents the gate voltage $V_g$, and the ordinate represents the drain current $I_{ds}$ or a transconductance $g_m$. A solid characteristic curve represents the square characteristics represented by equation (1). The ordinate corresponding to this characteristic curve represents the current $I_{ds}$ shown on the left side of Fig. 1. A dotted characteristic curve represents a change in transconductance with respect to a change in voltage of the FET gate voltage having these square characteristics. The ordinate corresponding to this characteristic curve represents the transconductance $g_m$ shown on the right side of Fig. 1. As shown in this graph, a change in drain current $I_{ds}$ exhibits the square characteristics as a function of a change in gate voltage $V_g$. The drain current $I_{ds}$ as an output signal does not change linearly and is distorted with respect to the gate voltage $V_g$ as an input signal. This characteristic curve must be linear if the FET characteristics are less distorted.

To change the square characteristics linearly, i.e., to reduce the distortion caused in the output, there is proposed a structure in which an impurity doping profile in an active layer must be changed stepwise or gradually (graded distribution) from a conventional uniform distribution. An FET having the stepwise impurity profile of an active layer is disclosed in, for example, U.S. Patent No. 4,163,984. This prior art describes an impurity profile in which an impurity is doped from a substrate surface to a predetermined depth at a constant concentration and the impurity concentration increases stepwise at a predetermined depth. When an active layer is formed using this impurity profile, a drain current linearly changes as a function of a gate voltage. Therefore, the output distortion can be reduced.

In the conventional MESFET, however, to change the impurity profile of the active layer stepwise or in a graded manner, the following problem is posed.

To realize such a special impurity profile structure, it is necessary to epitaxially grow an impurity-doped semiconductor thin film in a predetermined concentration in accordance with an epitaxial growth method. Therefore, the impurity concentration for epitaxially growing a thin film must be precisely controlled, and an FET having a predetermined impurity profile can not be easily manufactured.

It is difficult to manufacture FETs having different threshold voltages $V_{th}$ on a single wafer because active layers are formed by the epitaxial growth method, which greatly limits the design of semiconductor integrated circuits. For example, FETs constituting an input/output buffer must have the same threshold voltage $V_{th}$ as that of FETs constituting a functional section due to this circuit design limitations.

It is possible to recess some gate electrodes to obtain FETs having a threshold voltage $V_{th}$ different from that prior to formation of a recessed structure after FETs having the same threshold voltage $V_{th}$ are formed. However, a method of forming the recess in an active layer is generally wet etching. This makes it difficult to uniformly form recesses on a single wafer with good reproducibility.

In an FET structure having a stepwise or graded impurity distribution of the active layer, the impurity concentration of the substrate surface is kept low. For this reason, ohmic contact resistances of source and drain electrodes formed in contact with this low concentration layer are set high.

## SUMMARY OF THE INVENTION

The present invention has been made to solve these conventional problems described above, and has as its object to provide a MESFET in which linearity of $V_g$-$I_{ds}$ characteristics can be improved without specifying the impurity profile of an active layer.

In order to achieve the above object of the present invention, there is provided a MESFET arranged such that an active layer Schottky-contacting a gate electrode, a high concentration layer ohmic-contacting a drain electrode and having a high impurity concentration, and an intermediate concentration layer formed between the high concentration layer and the active layer and having an impurity concentration lower than that of the high concentration layer are formed in a semiconductor substrate, wherein the high concentration layer is formed at a substrate position spaced apart from the gate electrode by a predetermined distance and has an impurity concentration and thickness so that a surface depletion layer generated depending on a surface level on the drain-side does not almost extend to the drain-side, the intermediate concentration layer has an impurity concentration and thickness so that a drain-side end portion of a channel depletion layer generated upon applying a voltage to the gate electrode extends to the drain-side with an increase in this applied voltage, and the high concentration layer, a distance between the high concentration layer and the gate electrode, and the intermediate concentration layer are formed to have a relationship in which a ratio of an extension length of a part of the channel depletion layer from the drain-side end portion of the gate electrode to the drain-side end of the part, to a gate length is 1/5 or more and 1 or less.

According to the present invention, there is provided a method of manufacturing the Schottky junction type field effect transistor, comprising the steps of: forming an active layer in a surface of a semiconductor substrate; forming a dummy gate on the active layer using a resist; ion-implanting an impurity at a predetermined dose and a predetermined acceleration energy using the dummy gate as a mask, thereby forming a high concentration layer at least on a drain-side; reducing outer dimensions of the dummy gate by a predetermined size; ion-implanting an impurity at a predetermined dose and a predetermined acceleration energy using a reduced dummy gate as a mask, thereby forming an intermediate concentration layer having an impurity concentration lower than that of the high concentration layer on at least the drain-side; forming an insulating film on the dummy gate and then performing a lift-off process of the dummy gate to form an inverted pattern at a position where the dummy gate was present; and forming a gate electrode Schottky-contacting the active layer exposed in the inverted pattern and a drain electrode ohmic-contacting the high concentration layer exposed therein.

According to the present invention, there is also provided a method of manufacturing the Schottky junction field effect transistor, comprising the steps of: forming an active layer in a surface of a semiconductor substrate; forming a gate electrode on the active layer using a refractory metal, ion-implanting an impurity at a predetermined dose and a predetermined acceleration energy using the gate electrode as a mask, thereby forming an intermediate concentration layer on at least a drain-side; forming a side wall having a predetermined thickness on a side surface of the gate electrode on the drain-side; ion-implanting an impurity at a predetermined dose and a predetermined acceleration energy using the gate electrode and the side wall as masks, thereby forming a high concentration layer having an impurity concentration higher than that of the intermediate concentration layer on at least the drain-side; and forming a drain electrode ohmic-contacting the high concentration layer.

The high concentration layer is formed at the position spaced apart from the gate electrode by a predetermined distance, and the end portion of the channel depletion layer extends to the drain-side to some extent. For these reasons, a rate of increase in drain current with an increase in gate voltage can be lowered. That is, a long gate effect tends to occur. On the other hand, the intermediate concentration layer having the predetermined impurity concentration and thickness is formed between the high concentration layer and the active layer Schottky-contacting the gate electrode to suppress extension of the end portion of the channel depletion layer toward the drain-side. A change in drain current tends to occur with a change in gate voltage in accordance with the square characteristics. Therefore, the long gate effect and the effect for changing the drain current in accordance with the square characteristics cancel each other. For this reason, the drain current linearly changes with a change in gate voltage, an FET output changes linearly in response to an input, and output distortion can be eliminated.

The high and intermediate concentration layers can be formed by the ion-implantation method, and an epitaxial growth method using precise impurity control need not be used. For this reason, an FET free from output distortion can be easily manufactured. Use of the ion-implantation method facilitates selective formation of the high and intermediate concentration layers on the substrate. Accordingly, FETs having different threshold voltages can be formed on a single substrate. In addition, the impurity concentration on the substrate surface has a value enough to achieve a sufficiently low ohmic-contact resistance. Therefore, the contact resistance of the ohmic electrode can be sufficiently reduced.

According to the present invention, as described above, linearity of the drain current as a function of gate voltage can be improved even in a MESFET having an ion-implanted impurity profile. Therefore, the present invention can be effectively used for a basic element for a circuit such as a high-power signal amplifier which requires a small output signal distortion in response to an input signal.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art form this detailed description.

BRIEF DESCRIPTION OF THE DRAWINGS

Fig. 1 is a graph showing typical square characteristics of a MESFET;

Figs. 2 to 4 are sectional views showing the steps in the manufacture of the MESFET according to the first embodiment of the present invention;

Figs. 5 to 7 are sectional views for explaining operations of the first embodiment according to the present invention;

Figs. 8 and 9 are graphs showing $V_{gs}$-$I_{ds}$ and $V_{gs}$-$g_m$ characteristics obtained in correspondence with an FET shown in Figs. 5 to 7;

Fig. 10 is a graph for explaining the concept of linearity of the FET according to the present invention;

Fig. 11 is a graph showing $V_g$-$g_m$ characteristics using a side-etch amount as a parameter in the MESFET having a structure of the first embodiment;

Fig. 12 is a graph showing $V_g$-$g_m$ characteristics using a gate length as a parameter in the MESFET having the structure of the first embodiment;

Fig. 13 is a graph showing the relationship between a gate length $L_g$ and a side-etch amount $L_{g-n+}$ to obtain a highly linear FET when $n^+$- and n'-type layers are formed under specific conditions;

Fig. 14 is a graph showing the relationship between an Si dose and side-etch amount $L_{g-n+}$ to obtain a highly linear FET when an $n^+$-type layer is formed under specific conditions;

Fig. 15 is a graph showing the relationship between a peak carrier concentration and a side-etch amount $L_{g-n+}$ to obtain a highly linear FET when an $n^+$-type layer is formed under specific conditions;

Fig. 16 is a graph showing the relationship between an Si dose and side-etch amount $L_{g-n+}$ to obtain a highly linear FET when an n'-type layer is formed under specific conditions;

Fig. 17 is a graph showing the relationship between a peak carrier concentration and a side-etch amount $L_{g-n+}$ to obtain a highly linear FET when an n'-type layer is formed under specific conditions;

Figs. 18 to 20 are sectional views showing the steps in the manufacture of the MESFET according to the second embodiment of the present invention;

Figs. 21 to 25 are sectional views showing the steps in the manufacture of the MESFET according to the third embodiment of the present invention; and

Fig. 26 is a sectional view showing an FET structure having another formation position of an n'-type layer.

DETAILED DESCRIPTION OF THE PREFERRED EMBODIMENTS

Figs. 2 to 4 are sectional views showing the method of manufacturing a GaAs MESFET according to the first embodiment of the present invention.

Si ions are implanted to an FET formation region on a semi-insulating GaAs semiconductor substrate 1. By this ion implantation, an active layer 2 containing an n-type impurity in a predetermined concentration is formed to have a predetermined thickness on the substrate surface. A resist is spin-coated on the active layer 2 and a gate pattern is transferred to the resist to form a dummy gate 3. Then, Si ions are implanted using the patterned dummy gate 3 as a mask to form an $n^+$-type layer (high concentration layer) 4 (Fig. 2). This ion implantation for forming the $n^+$-type layer 4 is performed at an acceleration energy of 90 keV and a does of $2 \times 10^{13}$ [1/cm$^2$].

The outer dimensions of the dummy gate 3 are isotropically reduced by reactive ion etching (RIE) using an $O_2$ plasma. As a result, the active layer 2 covered with the dummy gate 3 is partially exposed. Si ions are implanted again using a reduced dummy gate 3a as a mask. This ion implantation is performed at an acceleration energy of 30 keV and a dose of $3 \times 10^{12}$ [1/cm$^2$]. An n'-type layer 5 is formed in the exposed portion of the active layer 2 by this ion implantation (Fig. 3). The width of this n'-type layer 5 is determined by the degree of reduction of the dummy gate 3, i.e., a side-etch amount $L_{g-n+}$. This side-etch amount $L_{g-n+}$ determines a distance between the $n^+$-type layer 4 and a gate electrode (to be described later).

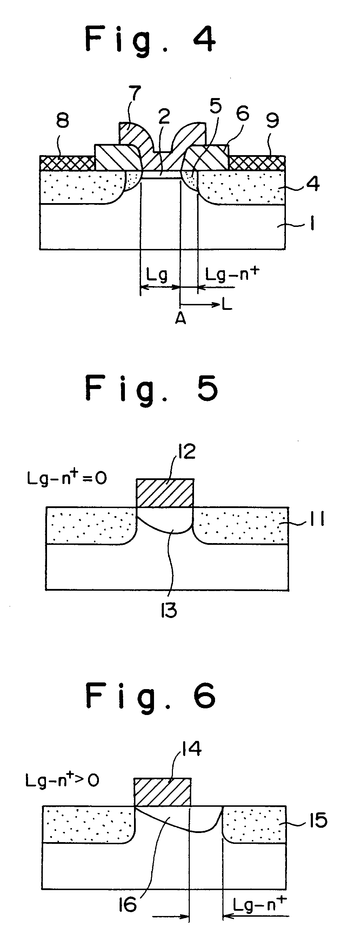

After an $SiO_2$ film is deposited on the entire surface of the substrate 1 using sputtering, the reduced dummy gate 3a is lifted off. By this lift-off process, an inverted pattern is formed on an $SiO_2$ film 6 at a trace of the dummy gate 3a. Thereafter, annealing for activating the implanted Si ions is performed. Then, a gate electrode 7 to Schottky-contact the exposed active layer 2 is formed on the inverted pattern using Ti/Pt/Au metals. After the $SiO_2$ film 6 on the $n^+$-type layer 4 is selectively removed, a source electrode 8 and a drain electrode 9, which respectively ohmic-contact the $n^+$-type layer 4, are formed using Au/Ge/Ni metals (Fig. 4). As a result, a MESFET is completed.

In the MESFET according to this embodiment, the $n^+$-type layer 4 is formed at a substrate position apart from the gate electrode 7 by the distance of the side-etch amount $L_{g-n+}$. In addition, the $n^+$-type layer 4 has an impurity concentration and thickness such that a surface depletion layer generated depending on a surface level on the drain-side does not almost extend to the drain-side. Accordingly, the influence of the surface depletion layer on a channel depletion layer can be reduced, and movement of electrons flowing in a current channel is controlled by the channel depletion layer without being influenced by the surface depletion layer.

The $n'$-type layer 5 as an intermediate concentration layer having a lower impurity concentration than that of the $n^+$ layer 4 has an impurity concentration and thickness such that a drain-side end portion of a channel depletion layer generated upon applying a voltage to the gate electrode 7 extends to the drain-side with an increase in this applied voltage. Moreover, the $n^+$-type layer 4, a distance $L_{g-n+}$ between the $n^+$-type layer 4 and the gate electrode 7, and the $n'$-type layer 5 are formed to have a relationship in which a ratio of an extension length L of a part of the channel depletion layer from the drain-side end portion A of the gate electrode 7 to the drain-side end of the part, to a gate length $L_g$ is to fall within a predetermined range.

In a MESFET having a gate length of 1 $\mu$m or less, a considerably strong electric field is generated in the drain-side of the depletion layer. If a MESFET is formed using a material (e.g., GaAs) having a lot of surface levels, a source resistance increases on the source side, and the channel depletion layer extends outward on the drain-side, as compared with the actual gate. A "long gate effect" which effectively increases a gate length is caused. For this reason, in a conventional structure, an $n^+$-type region self-aligned with a gate electrode is formed in a source/drain region, thereby eliminating the influences of the surface level.

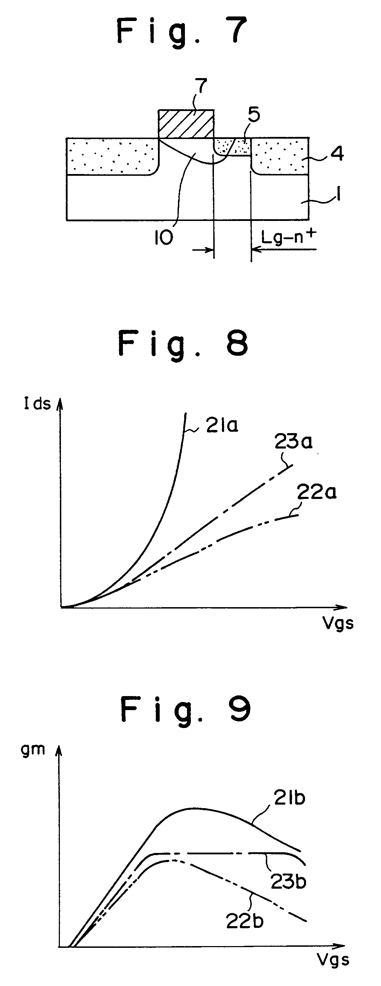

In a MESFET having a side-etch amount $L_{g-n+}$ = 0 shown in Fig. 5, an $n^+$-type layer 11 is self-aligned with a gate electrode 12, and the gate electrode 12 is adjacent to the $n^+$-type layer 11 on the drain-side. For this reason, although the influence of the surface level can be eliminated, a channel depletion layer 13 does not extend toward the drain-side. The voltage vs. current characteristics of this MESFET exhibit square characteristics represented by a solid curve 21a in the graph of Fig. 8, thereby causing output distortion. In this case, the abscissa represents the gate voltage $V_{gs}$ [V], and the ordinate represents the drain current $I_{ds}$ [A]. The transfer function characteristics of the MESFET are represented by a solid curve 21b in the graph of Fig. 9, and the $g_m$ value cannot be kept constant upon a change in gate voltage. In this graph, the abscissa represents the gate voltage $V_{gs}$ [V], and the ordinate represents the transconductance $g_m$.

To solve this problem, a distance of a side etch amount $L_{g-n+} > 0$ is set between the gate electrode 14 and the $n^+$-type layer 5, as shown in Fig. 6. If an MESFET having no $n'$-type layer is arranged, a channel depletion layer 16 extends considerably on the drain-side. In contrast, the long gate effect is caused. That is, the voltage vs. current characteristics of the MESFET are represented by a chain double-dashed-line curve 22a in the graph of Fig. 8. A rate of increase in drain current with an increase in gate voltage is reduced, and linearity is low. In addition, the transfer function characteristics of the MESFET are represented by a chain double-dashed-line curve 22b in the graph of Fig. 9, and the $g_m$ value cannot be kept constant upon a change in gate voltage.

To the contrary, in a MESFET having an $n'$-type layer by assuring a predetermined distance in the side etch amount $L_{g-n+}$, i.e., in a MESFET schematically shown in Fig. 7, the above inconvenience does not occur. The structure of the drain-side impurity region in the MESFET according to this embodiment employs an LDD (Lightly Doped Drain) structure. In addition, in this LDD structure, the $n^+$-type layer 4 is formed appropriately away from the gate electrode 7, the impurity concentration of the $n'$-type layer 5 is lower than that of the $n^+$-type layer 4 by a predetermined amount. The thickness of the $n'$-type layer 5 is smaller than that of the $n^+$-type layer 4 by a predetermined amount. That is, the distance between the gate electrode 7 and the $n^+$-type layer 4 and the impurity concentrations and thicknesses of the $n^+$- and $n'$-type layers 4 and 5 are optimized relative to each other. For this reason, a channel depletion layer 10 extends appropriately on the drain-side, and the voltage vs. current characteristics of the MESFET are represented by a chain-line curve 23a in the graph of Fig. 8. The drain current changes linearly with a change in gate voltage, and output distortion can be eliminated. The transfer function characteristics of the MESFET are represented by a chain-line curve 23b in the graph of Fig. 9, and the $g_m$ value is kept constant upon a change in gate voltage.

In this embodiment, the $n^+$-type layer 4 is formed apart from the gate electrode 7 by the distance $L_{g-n+}$, and the n'-type layer 5 has the predetermined impurity concentration and thickness. For these reasons, the end portion of the channel depletion layer tends to extend toward the drain-side to some extent. As a result, a rate of increase in drain current with an increase in gate voltage is reduced. That is, the long gate effect tends to occur. On the other hand, the impurity concentration and thickness of the n'-type layer 5 formed between the active layer 2 and the $n^+$-type layer 4 are set to suppress extension of the end portion of the channel depletion layer on the drain-side, and the drain current tends to change with a change in gate voltage in accordance with the square characteristics. Therefore the long gate effect and the effect for changing the drain current in accordance with the square characteristics cancel each other. As a result, the change in drain current with a change in gate voltage becomes linear, and an output signal from the FET linearly corresponds to an input signal. Unlike the conventional case, the output distortion can be eliminated.

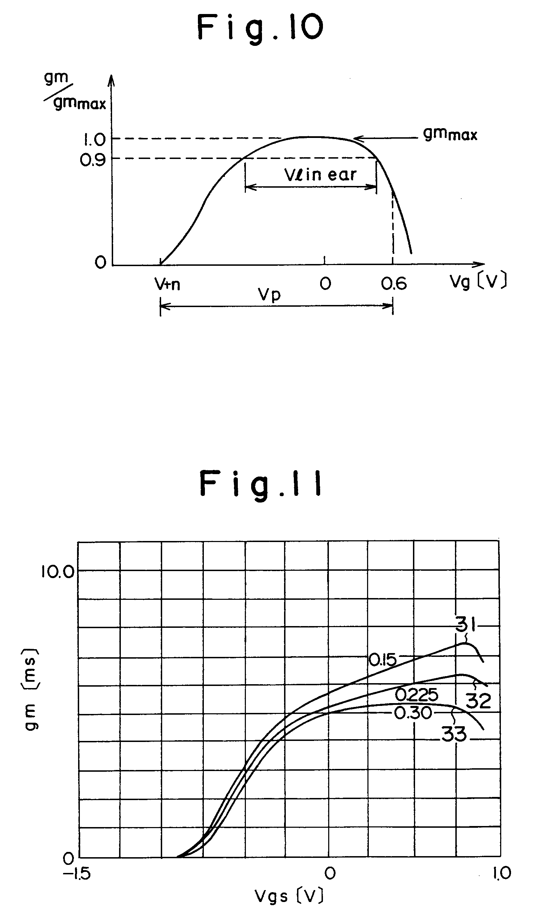

In this embodiment, the linearity of the MESFET is considered as follows. A graph in Fig. 10 represents a change in transconductance $g_m$ with a change in gate voltage $V_g$. The abscissa in this graph represents the gate voltage $V_g$ [V], and the ordinate represents a ratio $g_m/g_{mmax}$ of the transconductance $g_m$ to a maximum transconductance $g_{mmax}$. A characteristic curve in Fig. 10 represents a change in conductance ratio $g_m/g_{mmax}$ with a change in gate voltage $V_g$ when a drain-source voltage $V_{ds}$ is kept constant, e.g., 3.0 V. The maximum transconductance $g_{mmax}$ represents a maximum value of the transconductance $g_m$ of the characteristic curve. A range of transconductances $g_m$ having values as 90% or more of the maximum transconductance $g_{mmax}$ is defined as $V_{linear}$ as shown in Fig. 10. In the compound semiconductor FET such as a GaAs MESFET, the gate voltage $V_g$ will not be set at 0.6 V or more ($V_g > 0.6$ V), and an interval between the threshold voltage $V_{th}$ of the FET and the voltage of 6 V is defined as $V_p$ as shown in Fig. 10. The threshold voltage $V_{th}$ is a gate voltage in which a current channel formed in the active layer 2 pinches off. For example, if the threshold voltage $V_{th}$ of the FET is -2.0 V, $V_p$ is given as 2.6 V.

According to this embodiment, when the ratio of the linear voltage range $V_{linear}$ to the application voltage range $V_p$ of an FET is 50% or more ($V_{linear}/V_p > 0.5$) within the applied drain voltage (an applied voltage between a source electrode and a drain electrode) of 0.5 V to 10 V, this FET is regarded as a highly linear element. In a highly linear MESFET having the ratio $V_{linear}/V_p$ of 50% or more, the gain of a former-stage amplifier using small-signal amplification can be stabilized. When the ratio $V_{linear}/V_p$ is set to 70% or more, the distortion of a power amplifier which amplifies a large signal can be reduced.

In general, a MESFET having the following impurity profile has a ratio $V_{linear}/V_p$ of 50% or more and serves as a highly linear element. That is, when a high concentration layer corresponding to the $n^+$-type layer 4 and the intermediate concentration layer corresponding to the $n^-$-type layer 5 are formed by ion implantation for a MESFET having a gate length $L_g$ from 0.1 $\mu$m to 2.0 $\mu$, the peak concentration of the high concentration layer having the maximum impurity concentration is 1 x $10^{18}$ [1/cm$^3$] or more and a substrate depth at which an impurity concentration is 1 x $10^{17}$ [1/cm$^3$] is 0.1 $\mu$m or more and 0.25 $\mu$m or less . At the same time, the peak concentration of the intermediate concentration layer is 1 x $10^{17}$ [1/cm$^3$] or more and a substrate depth at which a concentration is 1 x $10^{16}$ [1/cm$^3$] is set to 0.20 $\mu$m or less. In addition, the side-etch amount $L_{g-n+}$ is set to fall within the range of 0.1 $\mu$m to 2.0 $\mu$m. An FET having this impurity profile is highly linear to obtain the same effect as in the above embodiment. In this case, when the depth from the substrate surface is plotted along the abscissa and the carrier concentration is plotted along the ordinate in such a manner that the substrate depth increases away from the origin along the abscissa and the concentration increases away from the origin along the ordinate, the impurity profiles of the high and intermediate concentration layers are almost inverted parabolic profiles. More specifically, the peak of the impurity concentration is located at a depth slightly lower from the substrate surface. When the substrate depth further increases, the impurity concentration parabolically decreases. The substrate position having the impurity concentration of 1 x $10^{17}$ - [1/cm$^3$] or 1 x $10^{16}$ [1/cm$^3$] is deeper than that of the peak impurity concentration.

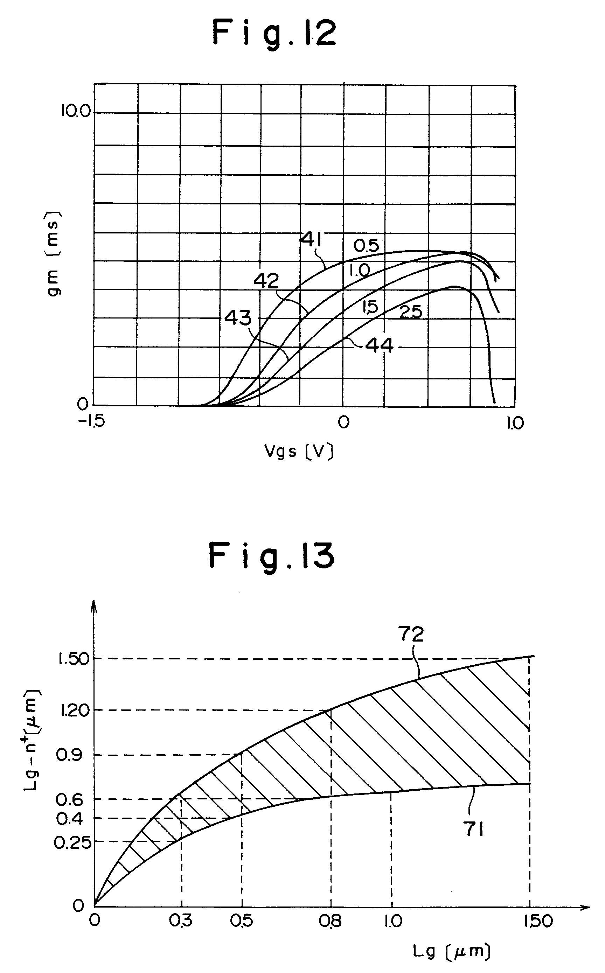

A graph in Fig. 11 shows a change in transconductance with respect to a change in a gate voltage using a side-etch amount $L_{g-n+}$ as a parameter in the MESFET structure having a gate length $L_g$ of 0.5 $\mu$m and a gate width $W_g$ of 20 $\mu$m according to this embodiment. The abscissa in this graph represents a gate-source voltage (gate voltage) $V_{gs}$ [V], and an interval between scale marks is 0.250/div. The ordinate of the graph in Fig. 11 represents a transconductance $g_m$, and an interval between the scale marks is 1.0/div.

The side-etch amount $L_{g-n+}$ as a parameter changes every 0.075 $\mu$m in an order of 0.15 $\mu$m, 0.225 $\mu$m, 0.30 $\mu$m,.... Characteristic curves 31, 32, and 33 correspond to side-etch amounts $L_{g-n+}$ of 0.15 $\mu$m, 0.225 $\mu$m, and 0.30 $\mu$m, respectively. As is apparent from this graph, in an FET having a gate length of 0.5 $\mu$m, the transconductance $g_m$ becomes kept constant even with a change in gate voltage when the side-etch amount $L_{g-n+}$ becomes about 0.30 $\mu$m. It is thus understood that linearity of the drain current change characteristics with a change in gate voltage can be improved.

A graph in Fig. 12 shows a change in transconductance as a function of the gate voltage using a gate length $L_g$ as a parameter in the MESFET structure having a gate width $W_g$ of 20 $\mu$m and a side-etch amount $L_{g-n+}$ of 0.30 $\mu$m according to this embodiment. The abscissa in this graph represents a gate voltage $V_{gs}$ [V], and an interval between scale marks is 0.2500/div. The ordinate of the graph in Fig. 12 represents a transconductance $g_m$,and an interval between the scale marks is 1.000/div.

The gate length $L_g$ as a parameter changes in an order of 0.5 $\mu$m, 1.0 $\mu$m, 1.5 $\mu$m, 2.0 $\mu$m,.... Characteristic curves 41, 42, 43, and 44 correspond to the gate lengths $L_g$ of 0.5 $\mu$m, 1.0 $\mu$m, 1.5 $\mu$m, and 2.0 $\mu$m, respectively. As is apparent from this graph, even when the side-etch amount $L_{g-n+}$ becomes about 0.30 $\mu$m, if the gate length becomes longer, the transconductance $g_m$ cannot be kept constant. It is thus understood that linearity of the drain current change characteristics with a change in gate voltage is degraded.

To eliminate an output distortion, it is understood from these drawings that the side-etch amount $L_{g-n+}$, i.e., the extension length L of the part of the channel depletion layer 10, which extends from the drain-side end portion A of the gate electrode 7 to the drain-side, and the gate length $L_g$ must be set to have a predetermined ratio. In addition, it is considered from these drawings that a ratio $L/L_g$ of an extension L of the channel depletion layer 10 to the drain-side to the gate length $L_g$ may be set 1/5 or more and 1 or less.

When the side-etch amount $L_{g-n+}$ is larger than the side-etch amount $L_{g-n+}$ = 0.30 $\mu$m at which the $g_m$ value is kept in constant, constancy of the $g_m$, i.e., linearity of the voltage vs. current characteristics is degraded. In this case, if the n'-type layer 5 is not formed between the active layer 2 and the n+-type layer 4, the channel depletion layer 10 may extend to the drain-side to an extent almost equal or more to the side-etch amount. At this time, a ratio $L/L_g$ of an extension L to the drain-side to the gate length $L_g$ is 0.6 (= 0.3/0.5) or more. The upper limit of the ratio $L/L_g$ can be 1 with a certain margin because the channel depletion layer 10 slightly extends into the n+-type layer 4. On the other hand, the lower limit of the ratio $L/L_g$ may be empirically determined to be 1/5 on the basis of the graphs described above.

If the relationship between the gate length $L_g$ and the side-etch amount $L_{g-n+}$ is defined in a graph of Fig. 13 under specific manufacturing conditions, it is empirically known that an FET having good linearity can be obtained. The specific manufacturing conditions are conditions in which an n-type impurity is ion-implanted at an acceleration energy of 90 to 120 keV and a dose of 4.0 x $10^{13}$ [1/cm$^2$] through an 800±50Å thick SiN film to form the n+-type layer 4, and an n-type impurity is ion-implanted at an acceleration energy of 50 keV and a dose of 6.0 x $10^{12}$ [1/cm$^2$] through an 800±50Å thick SiN film to form the n'-type layer 5. To further improve the linearity of the FET, the FET threshold voltage $V_{th}$ is set lower than -1.5 V to widen the linear voltage range $V_{linear}$.For this purpose, $^{29}$Si$^+$ is ion-implanted direct to the substrate at an acceleration energy of 30 keV or more to form the active layer 2. In addition, $^9$Be$^+$ is also ion-implanted direct to the substrate at an acceleration energy of 70 keV or more to obtain a steep carrier profile at the substrate interface between the active layer 2 and the substrate 1. When these manufacturing conditions are applied to the FET manufacturing process of the above embodiment, the SiN films through which ions are implanted are formed after the active layer 2 and the dummy gate 3 are formed. Ion-implanting operations are performed after such SiN films are formed, thereby satisfying the specific manufacturing conditions.

The abscissa in this graph represents the gate length $L_g$ [$\mu$m], and the ordinate represents the side-etch amount $L_{g-n+}$ [$\mu$m]. In a first curve 71 shown in this graph, the side-etch amount $L_{g-n+}$ gradually increases in the range of 0 to about 0.8 $\mu$m with an increase of 0 to about 1.5 $\mu$m in the gate length $L_g$. In a second curve 72, the side-etch amount $L_{g-n+}$ gradually increases in the range of 0 to about 1.5 $\mu$m with an increase of 0 to about 1.5 $\mu$m in the gate length $L_g$. According to the experiences of the applicant, if the relationship between the gate length $L_g$ and the side-etch amount $L_{g-n+}$ is defined in a hatched area in this graph in which the first curve 71 is the lower limit and the second curve 72 is the upper limit, it is empirically known that an FET having good linearity can be obtained. That is, if the relationship between the gate length $L_g$ and the side-etch amount $L_{g-n+}$ is set in a hatched area in this graph, and the specific manufacturing conditions are applied to the above embodiment to manufacture the MESFET, a highly linear FET is obtained, thereby obtaining the same effect as in the above embodiment.

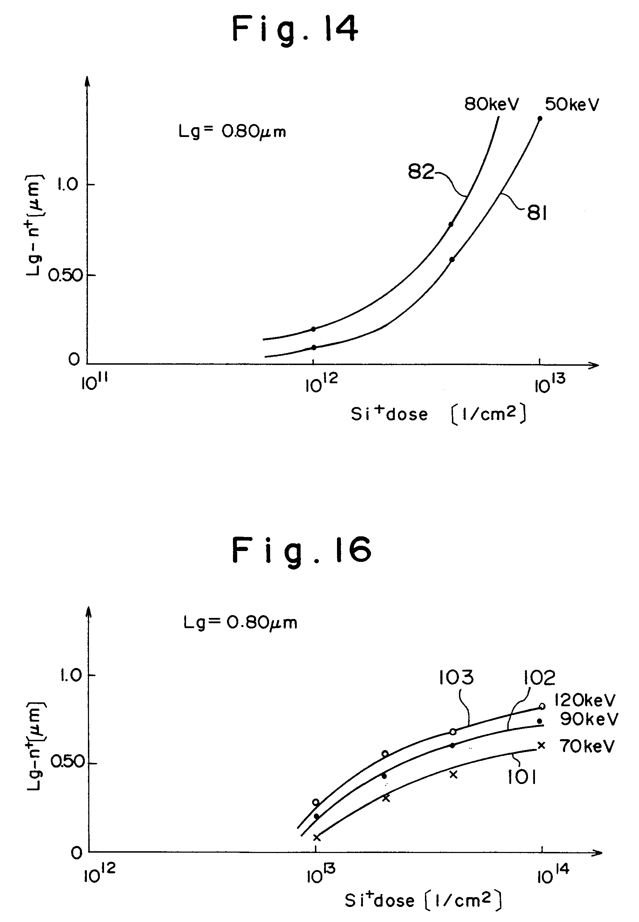

Assume that the gate length $L_g$ is 0.8 $\mu$m and that ion implantation for the $n^+$-type layer 4 is performed at an acceleration energy of 90 to 120 keV and a dose of 4.0 x $10^{13}$ cm$^{-2}$ through an 800±50Å thick SiN film. In addition the n'-type layer 5 is formed under the conditions represented in a graph of Fig. 14, it is empirically known that a highly linear element can be obtained. Ion implantation is also performed through an 800±50Å thick SiN film to form this n'-type layer 5. The abscissa in the graph of Fig. 14 represents a dose [cm$^{-2}$] of Si$^+$ ions, and the ordinate represents a side-etch amount $L_{g-n+}$ [$\mu$m]. Characteristic curves 81 and 82 in this graph respectively represent relationships between the Si doses of 50 and 80 keV and the side-etch amount $L_{g-n+}$. The characteristic curves 81 and 82 represent that the side-etch amounts $L_{g-n+}$ gradually increase within the range of about 0 to about 1.2 $\mu$m with an increase in dose of $10^{12}$ to $10^{13}$ cm$^{-2}$, using the acceleration energy as a parameter. When ion implantation for the n'-type layer 5 is performed under the condition that the relationships between the Si doses, the acceleration energies, and the side-etch amounts are conditions represented by the characteristic curves 81 and 82 to manufacture the FET of the above embodiment, a highly linear FET, i.e., an FET satisfying condition $V_{linear}/V_p > 0.7$ is obtained, thereby obtaining the same effect as in the above embodiment.

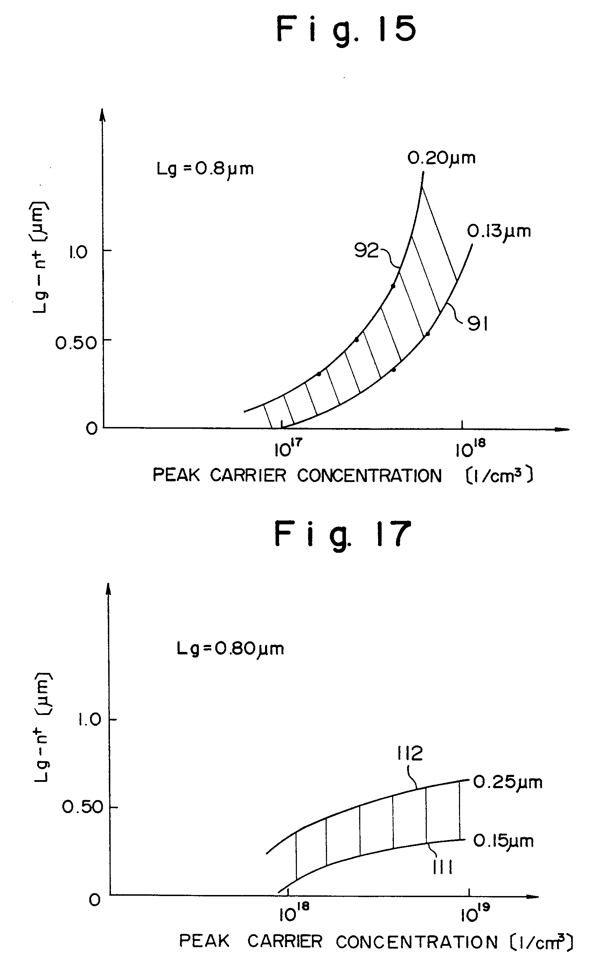

When the $n^+$-type layer 4 is formed under the specific conditions described above, and the n'-type layer 5 is formed in accordance with the relationship shown in Fig. 14, the relationship between the peak carrier concentration and the side-etch amount $L_{g-n+}$ of the n'-type layer 5 is shown in Fig. 15. The abscissa of this graph represents the peak carrier concentration [1/cm$^3$] of the n'-type layer 5, and the ordinate represents the side-etch amount $L_{g-n+}$ [$\mu$m] thereof. First and second curves 91 and 92 represent the relationships between the peak carrier concentrations and the side-etch amounts $L_{g-n+}$ when the depth of the n'-type layer 5 having a carrier concentration of 1 x $10^{16}$ [1/cm$^3$] from the substrate surface is used as a parameter. More specifically, the first curve 91 represents the relationship between the peak carrier concentration and the side-etch amount $L_{g-n+}$ using as a parameter a substrate depth of 0.13 $\mu$m at which the carrier concentration of the n'-type layer 5 is 1 x $10^{16}$ [1/cm$^3$]. The side-etch amount $L_{g-n+}$ gradually increases within the range of 0 to about 1.0 $\mu$m with an increase in peak carrier concentration in the range of 1 x $10^{17}$ [1/cm$^3$] to 1 x $10^{18}$ [1/cm$^3$]. The second curve 92 represents the relationship between the peak carrier concentration and the side-etch amount $L_{g-n+}$ using as a parameter a substrate depth of 0.20 $\mu$m at which the carrier concentration of the n'-type layer 5 is 1 x $10^{16}$ [1/cm$^3$]. The side-etch amount $L_{g-n+}$ gradually increases within the range of about 0.2 to about 1.5 $\mu$m with an increase in peak carrier concentration in the range of 1 x $10^{17}$ [1/cm$^3$] to 8 x $10^{17}$ [1/cm$^3$].

The first and second curves 91 and 92 represent that the substrate depth at which the carrier concentration is 1 x $10^{16}$ [1/cm$^3$] corresponding to a specific peak carrier concentration = x ($10^{17}$ to $10^{18}$ [1/cm$^3$]) and a specific side-etch amount $L_{g-n+}$ = y (0 to 1.5) fall within the range of 0.13 to 0.20 $\mu$m. That is, when the $n^+$-type layer 4 is formed under the specific conditions described above and the n'-type layer 5 is formed in accordance with the relationship shown in Fig. 14, the relationship between the peak carrier concentration, the substrate depth at which to the carrier concentration is 1 x $10^{16}$ [1/cm$^3$], and the side-etch amount $L_{g-n+}$ falls within a hatched area between the first and second curves 91 and 92 shown in Fig. 15. Therefore, an FET having $V_{linear}/V_p > 0.7$ can be obtained.

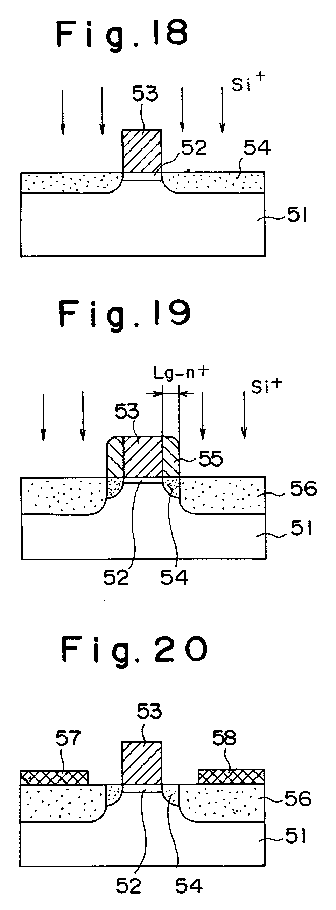

Assume that the gate length $L_g$ is 0.8 $\mu$m and that ion implantation for the n'-type layer 5 is performed at an acceleration energy of 50 keV and a dose of 6.0 x $10^{12}$ cm$^{-2}$ through an 800±50Å thick SiN film. In addition the $n^+$-type layer 4 is formed under the conditions represented in a graph of Fig. 16, it is empirically known that a highly linear element can be obtained. Ion implantation is also performed through an 800±50Å thick SiN film to form this $n^+$-type layer 4. The abscissa in the graph of Fig. 16 represents a dose [cm$^{-2}$] of Si$^+$ ions, and the ordinate represents a side-etch amount $L_{g-n+}$ [$\mu$m]. Characteristic curves 101 and 102 in this graph respectively represent relationships between the Si doses of 70 and 90 keV and the side-etch amount $L_{g-n+}$. Characteristic curve 103 represent relationship between the Si dose of 120 keV and the side-etch amount $L_{g-n+}$. The characteristic curves 101, 102, and 103 represent that the side-etch amounts $L_{g-n+}$ gradually increase within the range of about 0 to about 0.8 $\mu$m with an increase in dose of $10^{13}$ to $10^{14}$ cm$^{-2}$, using the acceleration energy as a parameter. When ion implantation for the $n^+$-type layer 4 is performed under the condition that the relationships between the Si doses, the acceleration energies, and the side-etch amount $L_{g-n+}$ are conditions represented by the characteristic curves 101, 102, and 103 to manufacture the FET of the above embodiment, a highly linear FET is obtained, thereby obtaining the same effect as in the above embodiment.

When the n'-type layer 5 is formed under the specific conditions described above, and the n+-type layer 4 is formed in accordance with the relationship shown in Fig. 16, the relationship between the peak carrier concentration and the side-etch amount $L_{g-n+}$ of the n+-type layer 4 is shown in Fig. 17. The abscissa of this graph represents the peak carrier concentration [1/cm³] of the n+-type layer 4, and the ordinate represents the side-etch amount $L_{g-n+}$ [μm] thereof. First and second curves 111 and 112 represent the relationships between the peak carrier concentrations and the side-etch amounts $L_{g-n+}$ when the depth of the n+-type layer 4 having a carrier concentration of 1 x 10¹⁷ [1/cm³] from the substrate surface is used as a parameter. More specifically, the first curve 111 represents the relationship between the peak carrier concentration and the side-etch amount $L_{g-n+}$ using as a parameter a substrate depth of 0.15 μm at which the carrier concentration of the n+-type layer 4 is 1 x 10¹⁷ [1/cm³]. The side-etch amount $L_{g-n+}$ gradually increases within the range of about 0.05 to about 0.35 μm with an increase in peak carrier concentration in the range of 1 x 10¹⁸ - [1/cm³] to 1 x 10¹⁹ [1/cm³]. The second curve 112 represents the relationship between the peak carrier concentration and the side-etch amount $L_{g-n+}$ using as a parameter a substrate depth of 0.25 μm at which the carrier concentration of the n+-type layer 4 is 1 x 10¹⁷ [1/cm³]. The side-etch amount $L_{g-n+}$ gradually increases within the range of about 0.35 to about 0.65 μm with an increase in peak carrier concentration in the range of 1 x 10¹⁸ - [1/cm³] to 1 x 10¹⁹ [1/cm³].

The first and second curves 111 and 112 represent that the substrate depth at which the carrier concentration is 1 x 10¹⁷ [1/cm³] corresponding to a specific peak carrier concentration = x (10¹⁸ to 10¹⁹ [1/cm³]) and a specific side-etch amount $L_{g-n+}$ = y (0.05 to 0.65) fall within the range of 0.15 to 0.25 μm. That is, when the n'-type layer 5 is formed under the specific conditions described above and the n+-type layer 4 is formed in accordance with the relationship shown in Fig. 16, the relationship between the peak carrier concentration, the substrate depth corresponding to the carrier concentration of 1 x 10¹⁷ [1/cm³], and the side-etch amount $L_{g-n+}$ falls within a hatched area between the first and second curves 111 and 112 shown in Fig. 17. Therefore, an FET having $V_{linear}/V_p > 0.7$ can be obtained.

The MESFETs described with reference to Figs. 13 to 17 are FETs having the following impurity profile in accordance with the manufacturing conditions described above. That is, when ion implantation is performed at a dose of 4.0 x 10¹³ [1/cm²] through an 800±50Å thick SiN film to form the n+-type layer 4, the peak carrier concentration of the n+-type layer 4 is 1 x 10¹⁸ [1/cm³] or more and 1 x 10¹⁹ [1/cm³] or less. When ion implantation is performed at an acceleration energy of 90 to 120 keV through an 800±50Å thick SiN film to form the n+-type layer 4, the depth having the carrier concentration of 1 x 10¹⁷ [1/cm³] from the substrate surface is 0.15 μm or more and 0.30 μm or less. When ion implantation is performed at a dose of 6.0 x 10¹³ [1/cm²] through an 800±50Å thick SiN film to form the n'-type layer 5, the peak carrier concentration of the n'-type layer 5 is 1 x 10¹⁷ - [1/cm³] or more and 1 x 10¹⁸ [1/cm³] or less. When ion implantation is performed at an acceleration energy of 50 keV through an 800±50Å thick SiN film to form the n'-type 5, the depth having the carrier concentration of 1 x 10¹⁸ [1/cm³] from the substrate surface is 0.15 μm or less.

In the MESFET according to the above embodiment, the n+-type and n'-type layers 4 and 5 are formed by the ion implantation. For this reason, the epitaxial growth method using precise impurity control need not be used. Therefore, according to the method of manufacturing an FET in this embodiment, an FET free from output distortion can be easily manufactured. Use of the ion-implantation method facilitates selective formation of the n+-type and n'-type layers 4 and 5 on the substrate. That is, a resist can be used as a mask to an FET group of one region on a wafer, and a predetermined impurity profile can be formed by ion implantation to an FET group of another region. Therefore, FETs having various types of threshold voltages $V_{th}$ can be formed on a single wafer, thereby solving the conventional limitations upon design of semiconductor integrated circuits. That is, FETs having characteristics necessary for respective portions of the integrated circuits are easily formed. Since an active layer need not be recessed by etching to obtain different threshold values, FETs with good reproducibility and uniformity can be obtained. Since the source and drain electrodes 8 and 9 are formed to contact the n+-type layer 4 having a sufficiently high impurity concentration, ohmic contact resistances can be sufficiently reduced. Therefore, unlike in a conventional FET having an impurity profile formed in a stepwise or graded manner, the problem that the impurity concentration of the substrate surface is lowered and that the ohmic contact resistances can not be sufficiently reduced does not occur.

The second embodiment of the present invention will be described below. Figs. 18 to 20 are sectional views showing the method of manufacturing a MESFET according to the second embodiment of the present invention.

Si ions are implanted to an FET formation region on a semi-insulating GaAs semiconductor substrate 51. By this ion implantation, an active layer 52 containing an n-type impurity in a predetermined concentration is formed to have a predetermined thickness on the substrate surface. Then, a refractory metal, e.g., a WSix, is deposited on the active layer 52. A gate pattern is formed on this refractory metal using the normal photoresist technique. The refractory metal is etched by RIE using the gate pattern to form a gate electrode 53. Si ions are implanted under given conditions using this gate electrode 53 as a mask to form an n'-type layer 54 as an intermediate concentration layer (see Fig. 18).

An $SiO_2$ film is deposited on the entire surface of the substrate using the atmospheric pressure CVD method. The deposited $SiO_2$ film is selectively removed by RIE to form a side wall 55 on the side surface of the gate electrode 53. Si ions are implanted in a high concentration using the gate electrode 53 and the side wall 55 as masks to form an $n^+$-type layer 56 (Fig. 19). A distance $L_{g-n+}$ between the gate electrode 53 and the $n^+$-type layer 56 is adjusted to a desired distance by setting the thickness of the side wall 55.

After the side wall 55 is selectively removed, an ohmic-electrode pattern is formed on the substrate surface using the normal photolithography. A source electrode 57 and a drain electrode 58, which respectively ohmic-contact the $n^+$-type layer 56, are formed using this pattern (Fig. 20). As a result, a MESFET is completed.

In the MESFET according to this embodiment, the $n^+$-type layer 56 is formed at a substrate position apart from the gate electrode 53 by the distance $L_{g-n+}$ corresponding to the thickness of the side wall 55. In addition, the $n^+$-type layer 56 has a predetermined impurity concentration and thickness so that a surface depletion layer generated depending on a surface level on the drain-side does not almost extend to the drain-side. Accordingly, the influence of the surface depletion layer on a channel depletion layer can be reduced, and movement of electrons flowing in a current channel is controlled by the channel depletion layer without being influenced by the surface depletion layer.

The n'-type layer 54 as an intermediate concentration layer having a lower impurity concentration than that of the $n^+$ layer 56 has an impurity concentration and thickness such that a drain-side end portion of the channel depletion layer generated upon applying a voltage to the gate electrode 53 extends to the drain-side with an increase in this applied voltage. Moreover, the $n^+$-type layer 56, the distance $L_{g-n+}$ between the $n^+$-type layer 56 and the gate electrode 53, and the n'-type layer 54 are formed to have a relationship in which a ratio of an extension length of the drain-side end portion of the channel depletion layer from the drain-side end portion of the gate electrode 53 to the drain-side, to a gate length $L_g$ is 1/5 or more and 1 or less.

In the MESFET according to the second embodiment, the drain current $I_{ds}$ linearly changes with a change in gate voltage $V_{gs}$, and output distortion can be eliminated as in the first embodiment. In this embodiment, an FET is formed by the ion implantation, and the epitaxial growth method need not be used unlike in a conventional FET, thereby easily manufacturing an FET. FETs having different threshold voltages can be formed on a single wafer, and ohmic contact resistances can be sufficiently reduced, thereby obtaining the same effect as in the first embodiment.

In the description of each of the above embodiments, the n'-type and $n^+$-type layers respectively on the source and drain-sides are formed symmetrically. However, the structure on the drain-side is the characteristic feature of the present invention. Therefore, the structure on the source side is not limited to the structure of each of the above embodiment.

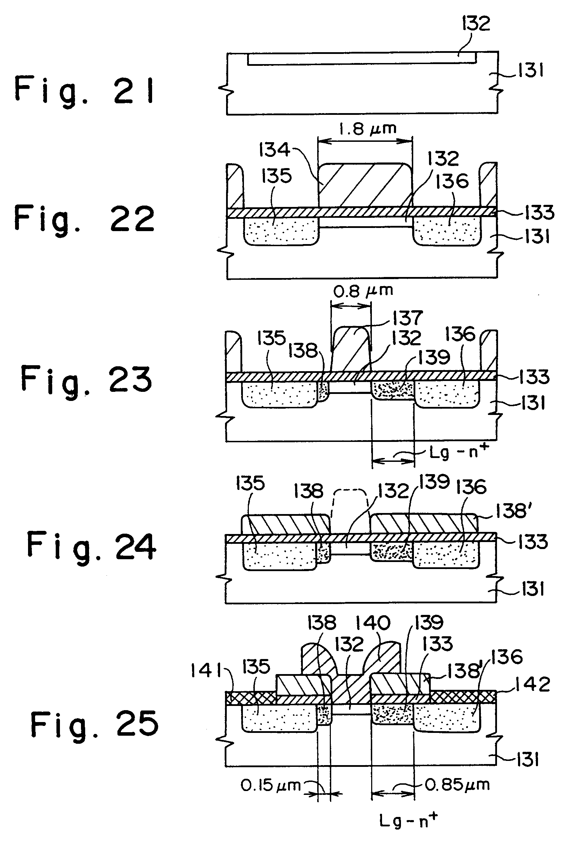

Next, the third embodiment according to the present invention will be explained hereinbelow. MESFET according to the third embodiment has a structure in which an ion implantation in a source side and an ion implantation in a drain side are non-symmetrical to each other with respect to a gate electrode. Figs 21-25 are sectional view showing the method of manufacturing the GaAs MESFET according to the third embodiment of the present invention.

An ion-implantation to an FET formation region on a semi-insulating GaAs semiconductor substrate 131 is performed. In the ion-implantation, $Si^+$ ions are implanted direct to the substrate at an acceleration energy of 50 KeV and a dose of $5 \times 10^{12}$ [1/$cm^2$]. By this ion implantation, an active layer 132 containing an n-type impurity in a predetermined concentration is formed to have a predetermined thickness on the substrate surface (see Fig. 21). Besides, $Be^+$ ions may be implanted to form a buried p-type layer at this time.

Next, a SiN layer 133 having thickness of 800±50Å is formed on the substrate surface. Thereafter, a resist is spin-coated on this SiN layer 133 and a $n^+$ region formation pattern is transferred on the resist 134. A length of the resist 134 is set to be 1.8 $\mu$m as shown in the drawing. Then an ion implantation is performed using this resist 134 as a mask and a source region 135 and a drain region 136 which are $n^+$ layers (high concentration layers) are formed (see Fig. 22). The ion implantation for formation of this $n^+$ layer is performed at acceleration energy of 120 Kev and a dose of $4 \times 10^{13}$ [1/$cm^2$] through the SiN layer 133.

Next the resist 134 on the substrate surface is removed and a new resist is coated on the SiN layer 133. The coated resist is patterned with a predetermined shape and a dummy gate 137 is formed at a position shifted near a source side. The length of the dummy gate 137 corresponds to that of a gate electrode (gate length) referred below and is set to be 0.8 $\mu$m. By the position of the dummy gate 137, a distance $L_{g-n+}$ between the gate electrode referred below and a gate side end portion of the drain region 136 is set to be 0.85$\mu$m. Next Si$^+$ ion is implanted using the dummy gate 137 as a mask so that n' layers 138 and 139 which are intermediate concentration layers, are formed (see Fig. 23). An ion implantation for formation of the n' layers 138 and 139 is performed at an acceleration energy of 50 KeV and a dose of 6 x $10^{12}$ [1/cm$^2$] through the SiN layer 133.

Next a SiO$_2$ layer 138' having a thickness of 300 Å is deposited on the substrate surface by a sputtering and thereafter, the dummy gate 137 is lifted off. By the lift-off process, an inverted pattern is formed on the SiO$_2$ layer 138' at a trace of the dummy gate 137 (see Fig. 24). Thereafter, annealing process having the annealing temperature of 870 °C and the annealing time of 5 seconds is performed for activating the implanted ion. Then a gate electrode 140 to Schottky-contact the exposed active layer 132 is formed on the inverted pattern using Ti/Pt/Au metals. After the SiO$_2$ layer 138' on the source region 135 and the drain region 136 is selectively removed, a source electrode 141 and a drain electrode 142, which respectively ohmic-contact the source region 135 and the drain region 136, are formed using Au/Ge/Ni metals (see Fig. 254). As a result, MESFET in which n' layers are formed non-symmetrically is completed.

In the MESFET of this embodiment, a gate length thereof is set to be 0.8 $\mu$m, the length of the n' layer 138 positioned near the source region 135 is set to be 0.15 $\mu$m and the length of the n' layer 139 positioned near the drain region 136 is set to be 0.85 $\mu$m. That is, the distance between the gate electrode 140 and a gate side edge of the source region 135 is short and the source region 135 is formed near the gate electrode 140. Accordingly in MESFET of the third embodiment, the high linearity of the FET output with respect to an input thereto can be realized by employment of the above structure of the n' layer 139 positioned near the drain region 136 and the drain region 136. Accordingly in the third embodiment, the advantageous effect obtained in the first and second embodiments can be obtained and further the source resistance can be extremely reduced by the above structure of the n' layer 138 near the source region 135 and the source region 135 and as the result, high speed operation and high range output can be realized also.

In the description of each of the above embodiments, GaAs is used as a substrate material. However, the present invention is not limited to this. For example, an InP material, an InGaAs material, or the like may be used to form the FET. The same effect as in each of the above embodiments can be obtained. Also, in the description of each of the above embodiments, Si is used as an n-type impurity. However, Se, S, or the like may be used as an n-type impurity. The same effect as in each of the above embodiments can be obtained using these materials.

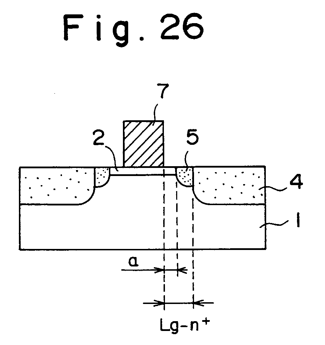

In the description of the structure according to each of the above embodiments, as shown in a schematic view of Fig. 7, the gate electrode 7 is adjacent to the n'-type layer 5 on the drain-side. However, the gate electrode 7 is not necessarily adjacent to the n'-type layer 5. Since the linearity of the MESFET is determined by the extension of the depletion layer on the drain-side, the n'-type layer 5 is formed at a substrate position slightly spaced apart from the gate electrode 7 by a distance $\underline{a}$, as shown in Fig. 26. Note that the same reference numerals in Fig. 26 denote the same parts as in Fig. 7, and a description will be omitted. In such a structure, the same effect as in each of the above embodiments can be obtained.

From the invention thus described, it will be obvious that the invention may be varied in many ways. Such variations are not to be regarded as a departure from the spirit and scope of the invention, and all such modifications as would be obvious to one skilled in the art are intended to be included within the scope of the following claims.

## Claims

1. A Schottky junction type field effect transistor arranged such that an active layer (2; 52; 132) Schottky-contacting a gate electrode (7; 53; 140), a high concentration layer (4; 56; 136) ohmic-contacting a drain electrode (9; 58; 142) and having a high impurity concentration, and an intermediate concentration layer (5; 54; 139) formed between said high concentration layer (4; 56; 136) and said active layer (2; 52; 132) and having an impurity concentration lower than that of said high concentration layer (4; 56; 136) are formed in a semiconductor substrate (1; 51; 131), wherein

said high concentration layer (4; 56; 136) is formed at a substrate position spaced apart from said gate electrode (7; 53; 140) by a predetermined distance and has an impurity concentration and thickness so that a surface depletion layer generated depending on a surface level on the drain-side does not almost extend to the drain-side,

said intermediate concentration layer (5; 54; 139) has an impurity concentration and thickness so that a drain-side end portion of a channel depletion layer generated upon applying a voltage to said gate electrode (7; 53; 140) extends to the drain-side with an increase in this applied voltage, and

said high concentration layer (4; 56; 136), a distance between said high concentration layer (4; 56; 136) and said gate electrode (7; 53; 140), and said intermediate concentration layer (5; 54; 139) are formed to have a relationship in which a ratio of an extension length of said drain-side end portion of said channel depletion layer from said drain-side end portion of the gate electrode (7; 53; 140) to the drain-side, to a gate length is not less than 1/5 and not more than 1.

2. A transistor according to claim 1, wherein when a voltage range of changes in the gate voltage having a value of not less than 90% of a maximum value of a transconductance $g_m$ changing with the change in the gate voltage and a gate voltage range from a voltage $V_{th}$ for pinching off a current channel formed in said active layer (2; 52; 132) to 0.6 V are defined as $V_{linear}$, and $V_p$, respectively, a ratio of the voltage range $V_{linear}$ to the voltage range $V_p$ is not less than 0.5 when a drain voltage applied to said drain electrode falls within a range of 0.5 V to 10 V.

3. A transistor according to claim 2, wherein the ratio of the voltage range $V_{linear}$ to the voltage range $V_p$ is not less than 0.7.

4. A transistor according to claim 2, wherein

a maximum value of an impurity concentration of said high concentration layer (4) is not less than $1 \times 10^{18}$ [1/cm$^3$], and a substrate depth at which said high concentration layer (4) has an impurity concentration of $1 \times 10^{17}$ [1/cm$^3$] is not less than 0.1 $\mu$m and not more than 0.25 $\mu$m from a substrate surface,

a maximum value of an impurity concentration of said intermediate concentration layer (5) is not less than $1 \times 10^{17}$ [1/cm$^3$], and a substrate depth at which said intermediate concentration layer has an impurity concentration of $1 \times 10^{16}$ [1/cm$^3$] is not more than 0.2 $\mu$m from the substrate surface, and

a distance $L_{g-n+}$ from said gate electrode (7) to a gate-side end portion of said high concentration layer (4) falls within a range of 0.1 $\mu$m to 2.0 $\mu$m, and the gate length falls within a range of 0.1 $\mu$m to 2.0 $\mu$m.

5. A transistor according to claim 2, wherein

a maximum value of an impurity concentration of said high concentration layer (4) is not less than $1 \times 10^{18}$ [1/cm$^3$] and not more than $1 \times 10^{19}$ [1/cm$^3$], and a substrate depth at which said high concentration layer (4) has an impurity concentration of $1 \times 10^{17}$ [1/cm$^3$] is not less than 0.15 $\mu$m and not more than 0.30 $\mu$m from a substrate surface,

a maximum value of an impurity concentration of said intermediate concentration layer (5) is not less than $1 \times 10^{17}$ [1/cm$^3$] and not more than $1 \times 10^{18}$ [1/cm$^3$], and a substrate depth at which said intermediate concentration layer (5) has an impurity concentration of $1 \times 10^{16}$ [1/cm$^3$] is not more than 0.15 $\mu$m from a substrate surface, and

in a graph having an abscissa representing the gate length and an ordinate representing the distance $L_{g-n+}$ between said gate electrode (7) and a gate-side end portion of said high concentration layer (4), a relationship between the gate length and the distance $L_{g-n+}$ is set within a range in which a first curve (71) gradually increasing the distance $L_{g-n+}$ within a range of 0 to about 0.8 $\mu$m with an increase in gate length of 0 to about 1.5 $\mu$m serves as a lower limit, and a second curve (72) gradually increasing the distance $L_{g-n+}$ within a range of 0 to about 1.5 $\mu$m with the increase in gate length of 0 to about 1.5 $\mu$m serves as an upper limit.

6. A transistor according to claim 2, wherein

a maximum value of an impurity concentration of said high concentration layer (4) is not less than $1 \times 10^{18}$ [1/cm$^3$] and not more than $1 \times 10^{19}$ (1/cm$^3$], and a substrate depth at which said high concentration layer has an impurity concentration of $1 \times 10^{17}$ [1/cm$^3$] is not less than 0.15 $\mu$m and not more than 0.30 $\mu$m from a substrate surface,

in a graph having an abscissa representing a maximum impurity concentration of said intermediate concentration layer and an ordinate representing the distance $L_{g-n+}$, a relationship between the maximum impurity concentration and the distance $L_{g-n+}$ is set within a range in which a first curve (91) gradually increasing the distance $L_{g-n+}$ within a range of 0 to about 1.0 $\mu$m with an increase in maximum impurity concentration of $1 \times 10^{17}$ to $1 \times 10^{18}$ [1/cm$^3$] serves as a lower limit, and a second curve (92) gradually increasing the distance $L_{g-n+}$ within a range of about 0.2 to about 1.5 $\mu$m with the increase in maximum impurity con-

centration of 1 x $10^{17}$ to 8 x $10^{17}$ [1/cm³] serves as an upper limit, using a substrate depth, from a substrate surface, which has an impurity concentration of 1 x $10^{16}$ [1/cm³] as a parameter, and

the gate length is set to 0.8 $\mu$m.

7. A transistor according to claim 2, wherein

in a graph having an abscissa representing a maximum impurity concentration of said high concentration layer (4) and an ordinate representing the distance $L_{g-n+}$, a relationship between the maximum impurity concentration and the distance $L_{g-n+}$ is set within a range in which a first curve (111) gradually increasing the distance $L_{g-n+}$ within a range of about 0.05 to about 0.35 $\mu$m with an increase in maximum impurity concentration of 1 x $10^{18}$ to 1 x $10^{19}$ - [1/cm³] serves as a lower limit, and a second curve (112) gradually increasing the distance $L_{g-n+}$ within a range of about 0.35 to about 0.65 $\mu$m with the increase in maximum impurity concentration of 1 x $10^{18}$ to 1 x $10^{19}$ - [1/cm³) serves as a upper limit, using a substrate depth, from a substrate surface, which has an impurity concentration of 1 x $10^{17}$ - [1/cm³] as a parameter,

a maximum value of an impurity concentration of said intermediate concentration layer (5) is not less than 1 x $10^{17}$ [1/cm³] and not more than 1 x $10^{18}$, and a substrate depth at which said intermediate concentration layer (5) has an impurity concentration of 1 x $10^{16}$ - [1/cm³] is set to not more than 0.15 $\mu$m from a substrate surface, and

the gate length is set to 0.8 $\mu$m.

8. A transistor according to claim 5, 6 or 7, further comprising a high concentration layer ohmic-contacting a source electrode (8) and having the same structure as that of said high concentration layer (4) ohmic-contacting said drain electrode (9).

9. A transistor according to claim 8, wherein said semiconductor substrate (1) consists of a compound semiconductor material selected from the group consisting of GaAs, InP, and InGaAs.

10. A transistor according to claim 9, wherein an n-type impurity consists of an element selected from the group consisting of Si, Se, and S.

11. A method of manufacturing the Schottky junction type field effect transistor of claim 1,

comprising

the first step forming said active layer (2; 132) in a surface of said semiconductor substrate (1; 131),

the second step forming a dummy gate (3; 134) on said active layer (2; 132) using a resist,

the third step of ion-implanting an impurity at a predetermined dose and a predetermined acceleration energy using said dummy gate (3; 134) as a mask, thereby forming said high concentration layer (4; 136) at least on the drain-side,

the fourth step of reducing outer dimensions of said dummy gate (3; 134) by a predetermined size,

the fifth step of ion-implanting an impurity at a predetermined dose and a predetermined acceleration energy using the reduced dummy gate (3a; 137) as a mask, thereby forming said intermediate concentration layer (5; 139) having an impurity concentration lower than that of said high concentration layer (4; 136) on at least the drain-side,

the sixth step of forming an insulating film (6; 138') on said dummy gate (3a; 137) and then performing a lift-off process of said dummy gate to form an inverted pattern at a position where said dummy gate (3a; 137) was present, and

the seventh step of forming said gate electrode (7; 140) Schottky-contacting said active layer (2; 132) exposed in the inverted pattern and said drain electrode (9; 142) ohmic-contacting said high concentration layer (4; 136).

12. A method according to claim 11, wherein

the third step comprises ion-implanting an n-type impurity at a dose of 4 x $10^{13}$ cm$^{-2}$ and an acceleration energy of 90 to 120 keV,

the fourth step comprises setting a relationship between the gate length and the reduced size $L_{g-n+}$ within a range in which a first curve (71) gradually increasing the distance $L_{g-n+}$ within a range of 0 to about 0.8 $\mu$m with an increase in gate length of 0 $\mu$m to about 1.5 $\mu$m serves as a lower limit, and a second curve (72) gradually increasing the distance $L_{g-n+}$ within a range of 0 to about 1.5 $\mu$m with the increase in gate length of 0 $\mu$m to about 1.5 $\mu$m serves as an upper limit in a graph having an abscissa representing the gate length and an ordinate representing the reduced size $L_{g-n+}$ of said dummy gate, and

the fifth step comprises ion-implanting an n-type impurity at a dose of 6 x $10^{12}$ cm$^{-2}$ and an acceleration energy of 50 keV.

**13.** A method according to claim 11, wherein

the second step comprises setting the size of said dummy gate (137) with a gate length of 0.8 $\mu$m,

the third step comprises ion-implanting an n-type impurity at a dose of 4 x $10^{13}$ cm$^{-2}$ and an acceleration energy of 90 to 120 keV,

the fourth step comprises setting the reduced size $L_{g-n+}$ of said dummy gate, and

the fifth step comprises ion-implanting the impurity for said intermediate concentration layer (139) such that a relationship between the reduced size $L_{g-n+}$ and a dose of the impurity to said intermediate concentration layer through an SiN film (133) is a predetermined relationship for gradually increasing the size $L_{g-n+}$ within a range of about 0 to about 1.2 $\mu$m with an increase in dose of $10^{12}$ to $10^{13}$ cm$^{-2}$ using the acceleration energy as a parameter in a graph having an abscissa representing the dose of the impurity and an ordinate representing the size $L_{g-n+}$.

**14.** A method according to claim 11, wherein

the second step comprises setting a size of said dummy gate with a gate length of 0.8 $\mu$m,

the third step comprises ion-implanting the impurity, and

the fourth step comprises setting the reduced size $L_{g-n+}$ of said dummy gate (137) such that a relationship between the reduced size $L_{g-n+}$ and a dose of the impurity to said intermediate concentration layer through an SiN film (133) is a predetermined relationship for gradually increasing the size $L_{g-n+}$ within a range of about 0 to about 0.8 $\mu$m with an increase in said dose of $10^{13}$ to $10^{14}$ cm$^{-2}$ using the acceleration energy as a parameter in a graph having an abscissa representing the dose of the impurity and an ordinate representing the size $L_{g-n+}$, and

the fifth step comprises ion-implanting the impurity at a dose of 6.0 x $10^{12}$ cm$^{-2}$ and an acceleration energy of 50 keV through an SiN film (133).

**15.** A method according to claim 12, 13 or 14, wherein

the third step comprises forming a high concentration layer (4; 135) on a source side in addition to said high concentration layer (4; 136) on the drain-side, and

the fifth step comprises forming an intermediate concentration layer (5; 138) on the source side in addition to said intermediate concentration layer (5; 139) on the drain-side.

**16.** A method of manufacturing the Schottky junction type field effect transistor of claim 1, comprising

the first step of forming said active layer (52) in a surface of said semiconductor substrate (51),

the second step of forming said gate electrode (53) on said active layer (52) using a refractory metal,

the third step of ion-implanting an impurity at a predetermined dose and a predetermined acceleration energy using said gate electrode (53) as a mask, thereby forming said intermediate concentration layer (54) on at least the drain-side,

the fourth step of forming a side wall (55) having a predetermined thickness on a side surface of said gate electrode (53) on at least the drain-side,

the fifth step of ion-implanting an impurity at a predetermined dose and a predetermined acceleration energy using said gate electrode (53) and said side wall (55) as masks, thereby forming said high concentration layer (56) having the impurity concentration higher than that of said intermediate concentration layer (54) on at least the drain-side, and

the sixth step of forming said drain electrode (58) ohmic-contacting said high concentration layer (56).

# Fig. 1

# Fig. 2

# Fig. 3

# Fig. 4

# Fig. 5

# Fig. 6

# Fig. 7

# Fig. 8

# Fig. 9

# Fig.10

# Fig.11

# Fig.12

# Fig.13

# Fig. 14

# Fig. 16

# Fig. 15

Lg = 0.8μm

0.20μm

0.13μm

92

91

Lg − n⁺ [μm]

1.0

0.50

0

10¹⁷    10¹⁸

PEAK CARRIER CONCENTRATION [1/cm³]

# Fig. 17

Lg = 0.80μm

112

0.25μm

0.15μm

111

Lg − n⁺ [μm]

1.0

0.50

0

10¹⁸    10¹⁹

PEAK CARRIER CONCENTRATION [1/cm³]

# Fig. 18

# Fig. 19

# Fig. 20

**Fig. 21**

**Fig. 22**

**Fig. 23**

**Fig. 24**

**Fig. 25**

# Fig. 26